# EUROPÄISCHE PATENTSCHRIFT

(11) **EP 2 691 743 B1**
(45) Veröffentlichungstag und Bekanntmachung des Hinweises auf die Patenterteilung: **11.01.2017**
(21) Anmeldenummer: 12701240.9
(22) Anmeldetag: 13.01.2012
(51) Int. Cl.: G01D 5/241, G01P 3/483, G01R 27/26

(54) **ANORDNUNG UND VERFAHREN ZUR KAPAZITIVEN ABTASTUNG DER DREHBEWEGUNG EINES DREHELEMENTS**
ARRANGEMENT AND METHOD FOR CAPACITIVE SENSING OF THE ROTARY MOVEMENT OF A ROTARY ELEMENT
AGENCEMENT ET PROCÉDÉ DE DÉTECTION CAPACITIVE DU MOUVEMENT DE ROTATION D'UN ÉLÉMENT ROTATIF.

(30) Priorität: 30.03.2011 DE 102011015589
(43) Veröffentlichungstag der Anmeldung: 05.02.2014
(73) Patentinhaber: Techem Energy Services GmbH, 65760 Eschborn (DE)
(72) Erfinder: REUS, Jürgen, 63579 Freigericht (DE)
(74) Vertreter: Keil & Schaafhausen Patent- und Rechtsanwälte PartGmbB
(86) Internationale Anmeldenummer: PCT/EP2012/050504
(87) Internationale Veröffentlichungsnummer: WO 2012/130485

(56) Entgegenhaltungen:
- EP-A1- 0 459 118
- EP-A1- 1 785 732

## Beschreibung

Die Erfindung betrifft eine Anordnung und ein Verfahren zur kapazitiven Abtastung der Drehbewegung eines Drehelements, wobei die Anordnung vier in einer Ebene angeordnete Elektroden, eine an die Elektroden angeschlossene Auswerteeinrichtung und eine elektrisch leitende Koppelfläche aufweist. Die Koppelfläche ist an dem Drehelement den Elektroden gegenüberliegend angeordnet und dient der kapazitiven Kopplung der Elektroden.

Die Elektroden umfassen eine zentrale Anregungselektrode, um die herum die übrigen Elektroden angeordnet sind, wobei die Koppelfläche in jeder Drehstellung der Fläche der Anregungselektrode gegenüberliegt und diese im Wesentlichen abdeckt. Die Koppelfläche deckt ferner einen Teil der durch die übrigen Elektroden gebildeten Fläche ab und überstreicht bei einer Drehung des Drehelements verschiedene Bereiche der durch die übrigen Elektroden gebildeten Fläche. Dadurch wird in jeder Drehstellung der Koppelfläche ein in der Wirkung gleicher Kondensator zwischen der Anregungselektrode und der elektrisch leitenden Koppelfläche gebildet, auf der sich die Ladung nach der Einkopplung durch die Anregungselektrode verteilt. Diese auf der Koppelfläche verteilte Ladung wird je nach Drehstellung auf die der Koppelfläche gegenüberliegenden Elektroden übertragen, welche um die Anregungselektrode herum angeordnet sind. Hierdurch wird zwischen den Elektroden, die in einer bestimmten Drehstellung der Koppelfläche gegenüberliegen, ein Kondensator ausgebildet. Es werden Elektronen induziert, die sich durch ein Spannungssignal an den Elektroden nachweisen lassen.

Um die Drehstellung des Drehelementes mit der Koppelfläche zeitaufgelöst nachweisen zu können, weist die Auswerteeinrichtung eine an die Anregungselektrode angeschlossene Anregungsschaltung zur Erzeugung von Anregungspulsen mit einer vorgegebenen Frequenz (Frequenzschaltung) und eine an die übrigen Elektroden angeschlossene Auswerteschaltung zum Erfassen der an den Elektroden anliegenden Spannungssignale und zum Vergleich dieser Spannungssignale auf.

Derartige Anordnungen zur kapazitiven Abtastung werden häufig bei Verbrauchszählern eingesetzt, insbesondere Wasserzählern, aber auch Strom- oder Gaszählern, bei denen der Verbrauch des verbrauchten Mediums über ein Abtastelement in eine Drehbewegung umgesetzt wird. Diese Drehbewegung wird dann über eine Kupplung, ein Getriebe und/oder eine Welle auf das Drehelement der Anordnung übertragen, an dem die Koppelfläche angeordnet ist.

Bei einem Wasserzähler dient meist ein Flügelrad zur Erfassung des Durchflusses. Die Drehbewegung des Flügelrades in dem Durchflussmesser ist ein Maß für den Volumenstrom und kann über elektrische Eigenschaften des Drehelementes in der erfindungsgemäßen Anordnung erfasst werden. Dies erfolgt durch eine halbseitig elektrisch leitfähige Metallbeschichtung des Drehelements, welche eine besonders geeignete Koppelfläche darstellt und kapazitiv mit den Elektroden der Sensoranordnung koppelt, die stationär angeordnet sind.

Ein Beispiel für eine derartige kapazitive Abtastung ist in der EP 1 785 732 A1 beschrieben, die eine Anordnung zum Detektieren einer Rotation eines Drehelementes mit auf einer im Wesentlichen planaren Fläche des Drehelementes vorgesehener elektrisch leitender Teilfläche und einem feststehenden Sensorelement mit einer Anregungselektrode und wenigstens zwei der Anregungselektrode benachbarten Empfängerelektroden aufweist. Die Elektroden stehen der elektrisch leitenden Teilfläche beabstandet gegenüber und sind bei Rotation des Drehelementes über die elektrisch leitende Teilfläche kapazitiv mit der Anregungselektrode koppelbar.

Die in der Anordnung vorgesehenen Detektionsmittel umfassen ein Spannungsmittel zum Beaufschlagen der Anregungselektrode mit einem Spannungspuls, dessen Spannung höher als die Spannung einer die Betriebsspannung der Anordnung zur Verfügung stellenden Batterie ist, sowie ein Auswertemittel zum Abgreifen von durch kapazitive Kopplung aufgrund des Spannungspulses erzeugten Empfängersignalen von wenigstens zwei Empfängerelektroden. Ferner ist ein Vergleichsmittel zur Erzeugung eines basierend auf den Empfängersignalen die Position der Teilfläche bezüglich den Empfängerelektroden anzeigenden Signals vorgesehen. Durch die Höhe des Spannungspulses, mit welchem die Anregungselektrode beaufschlagt wird, können Störeffekte von externen elektrischen Feldern bzw. Feldschwankungen reduziert werden. Dies ermöglicht es, auf eine in einer ähnlichen Anordnung gemäß der EP 1 033 578 B1 beschriebenen Kompensationselektrode mit der entsprechenden Elektronik zu verzichten. Gemäß der Lehre der EP 1 785 732 A1 können mit zwei Elektroden zwei verschiedene Stellungen des Drehelementes nachgewiesen werden. Um die Drehrichtung erkennen zu können, müssen jedoch vier verschiedene Stellungen des Drehelementes nachgewiesen werden. Hierfür sind dann vier Empfängerelektroden notwendig.

Die Detektion der Spannungssignale dieser vier Elektroden erfordert einen höheren Elektronikaufwand und vergleichsweise viel Bauraum für die Elektroden und die zu der Auswerteelektronik führenden Anschlussleitungen. Dieser Bauraum ist gerade bei einer Verwendung der erfindungsgemäßen Anordnung in einem Verbrauchszähler häufig nicht gegeben, da der Bauraum in Verbrauchszählern begrenzt ist.

Ein weiterer kapazitiver Stellungsgeber ähnlicher Bauart ist in der EP 0459118 A1 gezeigt.

Aufgabe der vorliegenden Erfindung ist es daher, eine vorteilhafte Möglichkeit zur kapazitiven Abtastung der Drehbewegung eines Drehelementes vorzuschlagen, bei dem der Aufwand für die Auswertung vermindert und der Bauraum für die Elektrodenanordnung insgesamt besonders klein ausgebildet werden kann.

Diese Aufgabe wird erfindungsgemäß bei einer Anordnung der eingangs genannten Art dadurch gelöst, dass die übrigen, die Anregungselektrode umgebenden Elektroden durch zwei Sensorelektroden und eine gemeinsame Referenzelektrode gebildet sind, wobei zumindest die gemeinsame Referenzelektrode von den Sensorelektroden verschieden ausgebildet ist. Ferner ist die Auswerteschaltung derart ausgebildet, dass jeweils eine Differenz des Spannungssignals zwischen einer der beiden Sensorelektroden und der gemeinsamen Referenzelektrode gebildet wird. Es werden also zwei Differenzsignale gebildet, sowohl zwischen der ersten der beiden Sensorelektroden und der gemeinsamen Referenzelektrode als auch zwischen der zweiten der beiden Sensorelektroden und der gemeinsamen Referenzelektrode.

Im Gegensatz zum Stand der Technik sind bei der vorliegenden Erfindung daher nur drei Elektrodensignale auszuwerten, die zu zwei Differenzsignalen zusammengefasst werden. Dies vereinfacht die Schaltung und ermöglicht den zur Verfügung stehenden Bauraum für weniger Elektroden zu nutzen, welche so - bei trotzdem kleinerem Platzbedarf - dennoch eine größere Elektrodenfläche aufweisen können und dadurch eine größere kapazitive Ankopplung mit vergrößerten Spannungssignalen erreichen. Insgesamt wird hierdurch die Störanfälligkeit der Anordnung reduziert und der notwendige Platzbedarf verringert.

Indem die gemeinsame Referenzelektrode von dem Sensorelektroden verschieden ausgebildet ist, ergeben sich durch die erfindungsgemäß gebildeten Differenzsignale zwei phasenversetzte Signale, aus denen die Drehrichtung des Drehelementes abgeleitet werden kann. Die von den Sensorelektroden verschiedene Ausbildung der Referenzelektrode bewirkt insbesondere eine asymmetrische Anordnung, bei der der durch die Referenzelektrode abgedeckte Winkelbereich bezogen auf einen vorzugsweise mit der Drehachse der Koppelfläche zusammenfallenden zentralen Punkt der Anregungselektrode von der Winkelabdeckung einer Sensorelektrode oder jeder der Sensorelektroden verschieden ist. Hierdurch wird erreicht, dass der Phasenversatz zwischen den beiden Signalen weder 0 noch 180° beträgt und somit eine Unterscheidung der Drehrichtung aufgrund der Asymmetrie der Anordnung mit der geeigneten Dimensionierung und Positionierung der übrigen Elektroden um die Anregungselektrode möglich ist.

Um eine geringe Störempfindlichkeit der Spannungssignale der Sensorelektroden bzw. der Referenzelektrode zu erreichen, beträgt die Pulshöhe des Anregungs- bzw. Spannungspulses, der in die Anregungselektrode eingespeist wird, vorzugsweise etwa 30 bis 35 V, d.h. entspricht etwa dem 10- bis 15-fachen der Batteriespannung einer Versorgungsbatterie der erfindungsgemäßen Anordnung, die typischerweise in der Größenordnung von 3 V liegt.

In Fortbildung der erfindungsgemäßen Anordnung kann das Ausbilden und Anordnen der beiden Sensorelektroden und der gemeinsamen Referenzelektrode vorzugsweise derart optimiert werden, dass der Phasenversatz der Spannungssignale von der ersten Sensorelektrode und der zweiten Sensorelektrode, gemessen an der Drehstellung der Koppelfläche, in der Größenordnung von 90° liegt, d.h. insbesondere zwischen 80° und 100° liegt.

Eine hierfür bevorzugte Anordnung sieht vor, dass bezogen auf die Anregungselektrode, die Sensorelektroden und die Referenzelektrode eine Symmetrieachse existiert, bezüglich derer die Form und Position der vorgenannten Elektroden in der Anordnung spiegelsymmetrisch ist. Vorzugsweise verläuft die Symmetrieachse durch einen zentralen Punkt der Anregungselektrode, bspw. den Mittelpunkt einer kreisförmig oder quadratisch ausgebildeten Anregungselektrode, wobei die Symmetrieachse vorzugsweise zusätzlich die Referenzelektrode spiegelsymmetrisch teilt und durch einen Zwischenraum zwischen den beiden Sensorelektroden verläuft. Mit einer solchen Anordnung lässt sich einfach ein Phasenversatz zwischen den Spannungssignalen der beiden Sensorelektroden in der Größenordnung von 90° erreichen.

Eine besonders effektive Anordnung liegt darin, dass die übrigen Elektroden die Anregungselektrode im Wesentlichen kreisförmig umgeben, wobei zwischen den beiden Sensorelektroden und zwischen jeder Sensorelektrode und der Referenzelektrode jeweils ein Zwischenraum besteht. Die Zwischenräume zwischen den einzelnen Elektroden können unterschiedlich groß sein. Im Wesentlichen kreisförmig soll bedeuten, dass jede Elektrode die zentral angeordnete Anregungselektrode in einem bestimmten Winkelbereich umgibt und jede Elektrode einen anderen Winkelbereich abdeckt. Ohne erfindungsgemäß darauf beschränkt zu sein, kann die Grundform einer der oder aller übrigen Elektroden ein Kreissegment sein. Um eine möglichst hohe Signalstärke zu erreichen, kann erfindungsgemäß ferner vorgesehen sein, dass die Zwischenräume zwischen den Elektroden insgesamt einen Winkelbereich von weniger als 90° um die Anregungselektrode aufweisen. Vorzugsweise liegt der Winkelbereich aller Zwischenräume zusammengenommen zwischen 50° und 80°. Dann steht der verbleibende Winkelbereich als Elektrodenfläche zur Verfügung, mit der sich durch die Kondensatoranordnungen der verschiedenen Elektroden mit der Koppelfläche ein vergleichsweise großes Spannungssignal erzeugen lässt, das weniger anfällig gegenüber externen Beeinflussungen ist.

Erfindungsgemäß kann es ferner vorteilhaft sein, wenn der Abstand zwischen den beiden Sensorelektroden größer ist als der Abstand zwischen einer Sensorelektrode und der Referenzelektrode, vorzugsweise um einen Faktor 3 bis 6. Hierdurch wird ein signifikant großer Phasenabstand zwischen den beiden erfindungsgemäß gebildeten Differenzen der Spannungssignale der einen bzw. der anderen Sensorelektrode und der Referenzelektrode begünstigt. Erfindungsgemäß kann der gewünschte Phasenabstand insbesondere auch durch die Größe der Zwischenräume geeignet eingestellt werden.

In einer bevorzugten Ausbildung der erfindungsgemäßen Anordnung kann die Referenzelektrode derart dimensioniert sein, das die Koppelelektrode in einer speziellen Drehstellung des Drehelements genau die Fläche der Referenzelektrode, ggf. mit den angrenzenden Zwischenräumen, abdeckt. In dieser Stellung ist das Spannungssignal an der Referenzelektrode maximal und das Spannungssignal an beiden an die Referenzelektrode an jeder Seite angrenzenden Sensorelektroden vergleichsweise niedrig. Auch durch eine derartige Anordnung wird ein geeigneter Phasenversatz zwischen den Spannungssignalen von der einen und der anderen Sensorelektrode in der Größenordnung von 90° begünstigt. Ferner können die Sensorelektroden und die Referenzelektrode derart dimensioniert und angeordnet sein, dass die Koppelfläche in jeder Drehstellung des Drehelementes höchstens zwei der drei übrigen Elektroden abdeckt oder derart dimensioniert und angeordnet sein, dass bei einer Abdeckung von drei übrigen Elektroden in einer Drehstellung mindestens eine der drei Elektroden eine Winkelabdeckung <50°, vorzugsweise <30°, aufweist. Dies führt zu einer besonders guten Entkopplung der verschiedenen Signale und damit einer besonders geeigneten Phasenverschiebung zwischen den Spannungssignalen der Sensorelektroden.

Eine besonders bevorzugte konkrete Anordnung kann erfindungsgemäß derart ausgebildet sein, dass die Anregungselektrode kreisförmig, die Koppelfläche in einem inneren Abschnitt kreisförmig und in einem dem inneren Abschnitt teilweise umgebenden äußeren Abschnitt halbkreisförmig ausgebildet sind und dass die gemeinsame Referenzelektrode einen Winkelbereich von etwa 140° bis 150° und jede Sensorelektrode ein Winkelbereich von etwa 50° bis 70° abdeckt. Dabei kann der innere Abschnitt der Koppelfläche in der Ausdehnung im Wesentlichen gerade, d.h. bis auf eine geringfügige Abweichung, der Ausdehnung der Anregungselektrode entsprechen. Hierdurch wird in jeder Drehstellung des Drehelementes eine gute kapazitive Ankopplung der Anregungselektrode an die Koppelfläche erreicht. Ferner kann in dieser konkreten Anordnung der Winkelbereich des Zwischenraums zwischen den beiden Sensorelektroden vorzugsweise zwischen 40° bis 50° betragen. In einer solchen Anordnung deckt die Koppelfläche in einer Drehstellung nur die Referenzelektrode ab, ggf. einschließlich der sich anschließenden Zwischenräume.

Gemäß einer sinnvollen Ausgestaltung der erfindungsgemäßen Anordnung kann die Auswertungsschaltung zwei Komparatoren aufweisen, die jeweils eine Differenz zwischen dem Spannungssignal der einen bzw. der anderen Sensorelektrode und dem Spannungssignal der Referenzelektrode bilden, wobei ein bzw. jeder Komparator nur bei einem oberhalb eines für beide gemeinsam oder getrennt einstellbaren Schwellenwertes liegenden Differenzwert ein Ausgangssignal gibt. Hierdurch lassen sich bei den erfindungsgemäß zwei Differenzsignalen vier unabhängige Zustände definieren, die jeweils einer Drehstellung der Koppelfläche relativ zu den Elektroden entsprechen. Bei der zuvor beschriebenen, optimierten Ausbildung und Positionierung der Elektroden lässt sich die Drehstellung der Koppelfläche damit in vier Quadranten zu je 90° einteilen und somit auch eine zuverlässige Drehrichtungserkennung verwirklichen, indem die Abfolge der nacheinander ermittelten Quadranten ausgewertet wird.

Vorzugsweise kann der Schwellenwert so eingestellt werden, dass der Schwellenwert etwa in der Mitte zwischen dem maximalen und dem minimalen gebildeten Differenzwert liegt. Dies kann durch eine geeignete Arbeitspunktverschiebung, bspw. durch Anschließen geeigneter Spannungsteiler, für die Spannungssignale der Sensorelektrode und der Referenzelektrode erfolgen. Die Auswertungsschaltung insgesamt kann bspw. durch einen Mikroprozessor realisiert sein, an dem die analogen Spannungssignale, ggf. nach der Arbeitspunktverschiebung, an den Eingängen erfasst und weiterverarbeitet werden. In den Mikroprozessor können insbesondere auch die beiden Komparatoren mit integriert sein.

Erfindungsgemäß kann die Anregungsschaltung zur Erzeugung von Spannungspulsen mit einer höheren Spannung, als sie durch eine Versorgungsbatterie der Anordnung insgesamt zur Verfügung gestellt wird, einen an die Versorgungsspannung der Batterie angeschlossenen Stromkreis mit einer Induktivität, einem Schalter und einer Einrichtung zur Strommessung (Strommesser) aufweisen, wobei die Anregungsschaltung dazu eingerichtet ist, den Schalter des Stromkreises zum Laden der Induktivität mit einem Ladestrom zu schließen und den Schalter bei Erreichen eines Ladestromschwellenwertes zum Ausbilden des Spannungspulses wieder zu öffnen. Dieser Vorgang wird mit der gewünschten Frequenz zur Abtastung der Drehstellung des Drehelementes wiederholt, bspw. angestoßen durch einen geeigneten Frequenzgeber. Vorzugsweise ist die Anregungsschaltung gleichzeitig weiter dazu eingerichtet, zur Manipulationsüberwachung die Ladezeit zwischen dem Schließen des Schalters und dem Erreichen des Ladestromschwellenwertes zu messen.

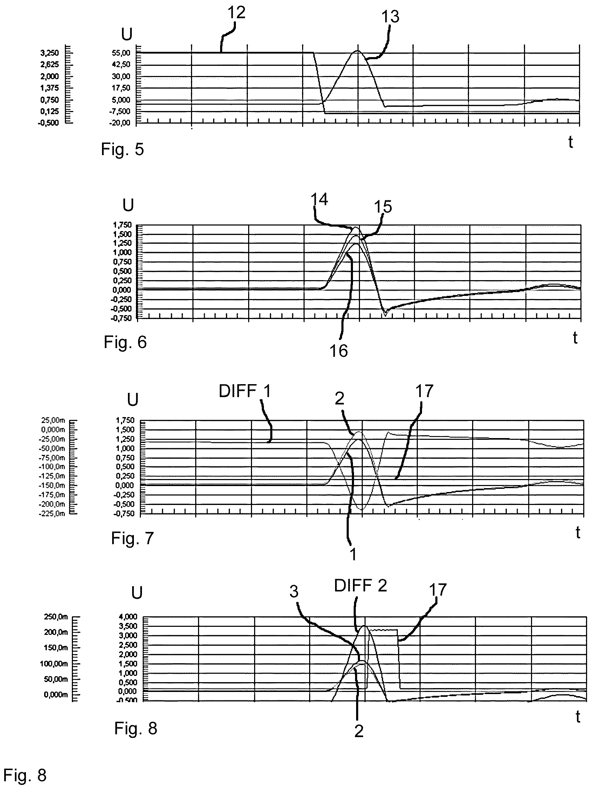

Da die Zeitkonstante des Ladestroms, d.h. die Steigung in einem Strom-Zeit-Diagramm entsprechend Fig. 6, von der Induktivität abhängt und die Induktivität durch ein von außen einwirkendes Permanentmagnetfeld so beeinflusst wird, dass der Ladestromschwellenwert nach dem Schließen des Stromkreises mit dem Schalter schneller erreicht wird, lässt sich ein derartiges extern zu Manipulationszwecken angelegtes Magnetfeld leicht erkennen, insbesondere bei Verwendung der Anordnung in einem erfindungsgemäßen Zähler, wie einem Wasserzähler. Mit der vorbeschriebenen Anordnung kann ein solches externes Magnetfeld also durch eine Messung der Ladezeit und einen Vergleich mit einem zuvor erfassten Normalwert festgestellt werden.

Bei einer Manipulation durch das Anlegen eines externen Magnetfelds kann die Zählung eines üblichen Zählers, insbesondere eines Wasserzählers, derart beeinflusst werden, dass kein Verbrauch mehr erfasst wird oder der Verbrauch zumindest nicht vollständig erfasst wird. Hintergrund ist, dass Zähler häufig eine Magnetkupplung zur Anbindung des Drehelementes mit der Koppelfläche an ein den Verbrauche erfassendes Bauteil aufweisen. Durch das Magnetfeld kann diese Anbindung beeinflusst werden, was ggf. zu einer niedrigeren Zählung führt. Außerdem vermindert sich die Höhe des durch die Spule erzeugten Spannungspulses, unter anderem weil der insgesamt über die Zeit fließende Ladestrom geringer ist. Dies kann zur Folge haben, dass die in dem Komparator definierten Schwellenwerte nicht mehr erreicht werden und überhaupt keine Zählung stattfindet. Eine derartige Manipulation kann durch die erfindungsgemäße Messung der Ladezeit der Induktivität zuverlässig erkannt werden, ohne dass eine zusätzliche Sensorik oder Elektronik eingesetzt werden muss. Daher wird durch die erfindungsgemäße Anordnung auch die Aufgabe gelöst, eine Manipulation durch ein externes Magnetfeld auf zuverlässige und technisch einfache Weise festzustellen. Die Zeitmessung lässt sich bspw. einfach in dem in der Anordnung ohnehin vorhandenen Mikroprozessor umsetzen.

Die Erfindung bezieht sich neben der Anordnung auch auf ein entsprechendes Verfahren zur kapazitiven Abtastung der Drehbewegung eines Drehelements mit einer Anordnung aus einer zentralen Anregungselektrode sowie einer Referenzelektrode und zwei Sensorelektroden, welche die zentrale Anregungselektrode umgeben, wobei die Anregungselektrode, die Referenzelektrode und die Sensorelektroden in einer Ebene und gegenüber einer an dem Drehelement vorgesehenen Koppelfläche angeordnet sind. Die Koppelfläche überdeckt die Anregungselektrode zumindest weitestgehend, sowie je nach Drehstellung Teile der übrigen Elektroden zur drehstellungsabhängigen kapazitiven Kopplung der Anregungselektrode mit der Referenzelektrode und den zwei Sensorelektroden. Es handelt sich erfindungsgemäß also insbesondere um ein Verfahren zur kapazitiven Abtastung der vorbeschriebenen Anordnung.

Bei dem Verfahren wird die Anregungselektrode mit einer vorgegebenen Frequenz mit Spannungs- bzw. Anregungspulsen beaufschlagt, wobei die resultierende Spannung der Referenzelektrode, der ersten Sensorelektrode und der zweiten Sensorelektrode gemessen werden. Um mit einer geringen Anzahl von Elektroden, einem niedrigen Platzbedarf und ohne großen schaltungstechnischen Aufwand eine Drehrichtungserkennung zu erreichen, wird erfindungsgemäß vorgeschlagen, dass die Differenzen der Spannung der einen bzw. der anderen Sensorelektrode jeweils mit der beiden Sensorelektroden gemeinsamen Referenzelektrode gebildet und ausgewertet werden, um die Bewegung und die Drehstellung des Drehelementes zu bestimmen. Der Mechanismus hierzu wurde bereits bei der Beschreibung der Anordnung erläutert, so dass hierauf Bezug genommen werden kann. Die Ausführungen für die Anordnung gelten für das erfindungsgemäße Verfahren entsprechend.

Gemäß einer bevorzugten Weiterbildung des erfindungsgemäßen Verfahrens können jeweils in einem Komparator einer Auswerteschaltung bei einer oberhalb eines Schwellenwertes liegenden Differenz der Spannung der einen Sensorelektrode und der Referenzelektrode und bei einer oberhalb eines, vorzugsweise desselben, Schwellenwertes liegenden Differenz der Spannung der anderen Sensorelektrode und der Referenzelektrode ein Ausgangssignal erzeugt werden, das in einer nachgeschalteten Logik einfach auswertbar ist.

Da die Spannungssignale der Sensorelektroden aufgrund der beschriebenen Anordnung der Sensorelektroden phasenversetzt sind, wirkt sich dieser Phasensatz auch auf die gebildeten Differenzen aus, so dass aus den durch die Komparatoren gelieferten Ausgangssignale auf die Drehstellung des Drehelementes mit der Koppelfläche geschlossen werden kann. Es sind bei zwei Komparatoren insgesamt vier verschieden Zustände unterscheidbar, so dass - bei geeigneter Anordnung und Ausbildung der Sensorelektroden und der Referenzelektrode - jeweils eine quadrantengenaue Positionsermittlung möglich ist. Durch Überwachung der aufeinanderfolgenden Quadranten kann dann die Drehrichtung ermittelt werden.

Erfindungsgemäß kann durch das vorgeschlagene Verfahren vorgesehen sein, dass ein an die Anregungselektrode abgegebener Anregungs- bzw. Spannungspuls erzeugt wird, indem ein Schalter in einem an einer Batterie angeschlossenen und eine Induktivität enthaltenen Stromkreis geschlossen und der Ladestrom überwacht wird, wobei der Schalter geöffnet wird, wenn der Ladestrom einen Ladestromschwellenwert erreicht.

Nach dem Öffnen des Schalters fließt aufgrund der Induktivität in dem Stromkreis zunächst weiter Strom und erzeugt dadurch eine Spannung, die größer ist als die durch die Batterie der Anordnung zur Verfügung gestellte Spannung. Die Höhe der Spannung wird durch die Dauer des Ladestroms und den Ladestromschwellenwert bestimmt und kann erfindungsgemäß so eingestellt werden, dass sie das 10- bis 15-fache der Batteriespannung erreicht. Bei einer Batteriespannung von 3 V liegt die bevorzugte Spannung des Spannungspulses bei etwa 30 bis 35 V, welche eine ausreichende Amplitude für die Auswerteschaltung ergibt. Der zeitliche Verlauf des Pulses ist im Wesentlichen sinusförmig und dessen Frequenz ist derart gestaltet, dass der Auswertekomparator diesen Puls erfassen kann. Die Frequenz kann durch den Frequenzgeber auch konfigurierbar sein. Damit kann die Position des Drehelements exakt bestimmt werden. Ergänzend kann die Ladezeit vom Schließen des Schalters bis zum Erreichen des Ladestromschwellenwertes überwacht werden. Hierdurch wird die bereits im Zusammenhang mit der Anordnung beschriebene Manipulationsüberwachung erreicht, die das Anlegen eines externen Magnetfeldes an der Anordnung feststellt, welches die Ladezeit beeinflusst. Gegebenenfalls kann durch das erfindungsgemäße Verfahren vorgesehen sein, dass die Anordnung im Falle einer Manipulation eine Meldung an einen die Verbrauchsdaten erfassenden Datensammler, vorzugsweise mittels einer Funkkommunikation, ausgibt. Dies kann bspw. dadurch realisiert werden, dass bei Über- und/oder Unterschreiten einer als Grenzwert vorgebbaren bzw. vorgegebenen Ladezeit bis zum Erreichen des Ladestromschwellenwertes (L) ein Fehlersignal erzeugt wird.

Schließlich betrifft die vorliegende Erfindung auch eine Verwendung einer Anordnung nach einem der Ansprüche 1 bis 7 in einem Verbrauchszähler, insbesondere einem Wasser-, Gas- oder Stromzähler, welcher einen drehbaren Verbrauchsensor mit einer Kupplung, insbesondere einer Magnetkupplung, aufweist, an welchen das Drehelement der Anordnung gemäß einem der Ansprüche 1 bis 7 ankoppelbar ist, wobei der Verbrauchszähler eine Recheneinheit zur Auswertung der durch die Anordnung gelieferten Drehstellung des Drehelementes und zur Umsetzung in Verbrauchswerte aufweisen. Erfindungsgemäß kann diese Recheneinheit auch in die Recheneinheit der zuvor beschriebenen Anordnung mit integriert sein. Ferner kann der Verbrauchszähler auch ein Kommunikationsmodul zur Funkübertragung der Verbrauchswerte und/oder von Fehlermeldungen, bspw. bei einer erkannten Manipulation, an einen Datensammler aufweisen. Auch das Kommunikationsmodul kann in ein die erfindungsgemäße Anordnung aufweisendes Modul integriert sein.

Mit der erfindungsgemäßen Anordnung und dem vorgeschlagenen Verfahren zur kapazitiven Abtastung der Drehbewegung eines Drehelementes wird aufgrund der auf einfache technische Weise erzeugbaren Spannungspulse mit einer Spannung in der Größenordnung zwischen 30 und 35 V eine Vergrößerung des Signal-Störabstandes und dadurch eine höhere Unempfindlichkeit der Anordnung gegenüber EMV-Störungen erreicht, wie sie bspw. durch Lampentrafos erzeugt werden.

Zudem ergibt die optimierte Geometrie der Anordnung eine sehr gute Aussteuerung der Signale, so dass durch das Mikroprozessorsystem eine robuste zuverlässige Auswertung der abgetasteten Spannungssignale realisiert werden kann.

Ferner ist eine Möglichkeit zur Erkennung der Manipulation durch ein extern erzeugtes Magnetfeld ohne weitere elektronische Komponenten möglich. Diese Manipulationserkennung ist besonders wirksam gegenüber häufig eingesetzten Manipulationsversuchen. Zur Manipulationserkennung wird der Ladestromverlauf der Induktivität ausgewertet. Hierdurch wird auch eine unzulässig hohe Stromentnahme aus der Batterie, welche in einem solchen Manipulationsfall auftreten würde, vermieden, da der Ladestrom der Spule im gestörten Betriebszustand durch den ohnehin vorgegebenen Ladestromschwellenwert begrenzt ist. Damit kann die von der Batterieleistung abhängige Einsatzdauer des Moduls auch bei Manipulationen sichergestellt werden.

Von Vorteil ist es, wenn das Mikroprozessorsystem bzw. die Auswerteeinrichtung der Anordnung die Zeitpunkte des Eintritts und ggf. der Behebung des durch die Manipulation mit einem stationärem Magnetfeld gestörten Betriebszustandes dokumentiert. Dies kann dadurch erreicht werden, dass der Zeitpunkt des Eintritts der Störung mit Datum und Uhrzeit in einem nicht flüchtigen Speicher abgelegt wird. Analog erfolgt dies, sobald der gestörte Betriebszustand nicht mehr vorliegt. So wird die Dauer der Störung dokumentiert und kann durch ein Servicegerät ausgelesen oder über ein Funktelegramm übertragen werden. Dies kann dann bei der Verbrauchskostenabrechnung berücksichtigt werden.

Weitere Vorteile, Merkmale und Anwendungsmöglichkeiten der vorliegenden Erfindung ergeben sich auch aus der nachfolgenden Beschreibung von Ausführungsbeispielen und der Zeichnung. Dabei bilden alle beschriebenen und/oder bildlich dargestellten Merkmale für sich oder in beliebiger Kombination den Gegenstand der vorliegenden Erfindung, auch unabhängig von ihrer Zusammenfassung in den Ansprüchen oder deren Rückbezügen.

Es zeigen:
- Fig. 1: schematisch die erfindungsgemäße Anordnung mit den Sensorelektroden, der Referenzelektrode und der Gegenelektrode;
- Fig. 2: die erfindungsgemäß zugehörige Koppelfläche des Drehelements;
- Fig. 3a: eine gemeinsame Anordnung der Elektroden und der Koppelfläche in einer ersten Drehstellung der Koppelfläche;
- Fig. 3b: eine gemeinsame Anordnung der Elektroden und der Koppelfläche in einer zweiten, gegenüber Fig. 3a um 90° verdrehten Drehstellung der Koppelfläche;
- Fig. 3c: eine gemeinsame Anordnung der Elektroden und der Koppelfläche in einer dritten, gegenüber Fig. 3b um 90° verdrehten Drehstellung der Koppelfläche;
- Fig. 3d: eine gemeinsame Anordnung der Elektroden und der Koppelfläche in einer vierten, gegenüber Fig. 3c um 90° verdrehten Drehstellung der Koppelfläche;
- Fig. 4: ein Diagramm mit an den Sensorelektroden und der gemeinsamen Referenzelektrode abgegriffen Spannungssignalen sowie mit den daraus gebildeten Differenzsignalen in Abhängigkeit von der Drehstellung der Koppelfläche.
- Fig. 5: ein Spannungs-Zeit-Diagramm mit dem Verlauf der Batteriespannung in dem Anregungsstromkreis und dem Pulsstrom in unterschiedlicher Skalierung und beliebigen Einheiten;
- Fig. 6: eine Variation der Spannungssignale der Sensorelektrode mit kleiner, mittlerer und hoher kapazitiver Abtastung je nach Stellung der Koppelfläche in beliebigen Einheiten;
- Fig. 7: ein Spannungs-Zeit-Diagramm mit den Spannungssignalen der ersten Sensorelektrode und der Referenzelektrode, dem aus den beiden Signalen gebildeten Differenzsignal und dem in Abhängigkeit von dem Wert des Differenzsignals gebildeten Ausgangssignal des Komparators in unterschiedlicher Skalierung und beliebigen Einheiten;
- Fig. 8: ein Spannungs-Zeit-Diagramm mit den Spannungssignalen der zweiten Sensorelektrode und der Referenzelektrode, dem aus den beiden Signalen gebildeten Differenzsignal und dem in Abhängigkeit von dem Wert des Differenzsignals gebildeten Ausgangssignal des Komparators in unterschiedlicher Skalierung und beliebigen Einheiten;
- Fig. 9: ein Prinzipschaltbild der Anregungsschaltung und der Auswertungsschaltung gemäß der erfindungsgemäßen Anordnung und
- Fig. 10: ein Strom-Zeit-Diagramm des Ladestroms der Induktivität zur Pulserzeugung.

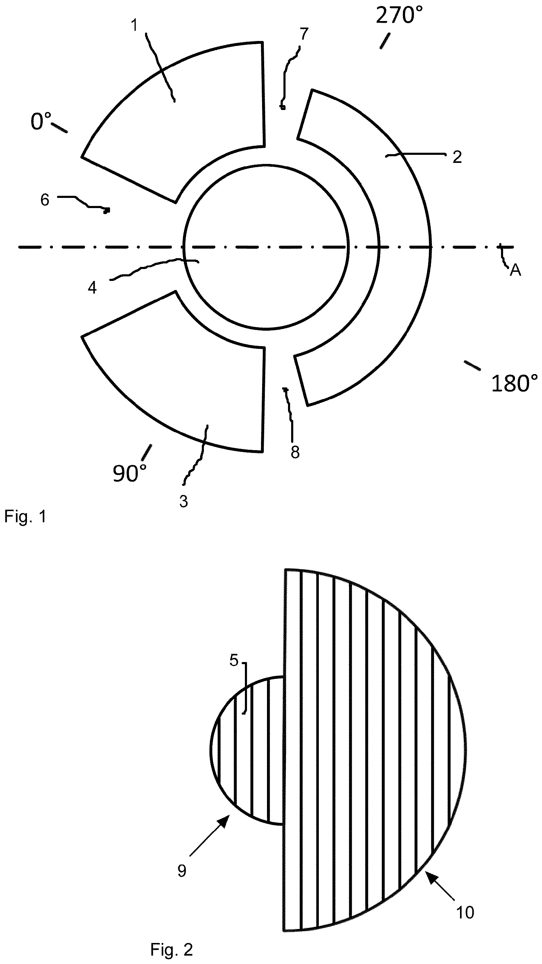

Fig. 1 stellt schematisch die Anordnung der Elektroden der erfindungsgemäßen Anordnung zur kapazitiven Abtastung der Drehbewegung eines Drehelementes dar. Diese Anordnung besteht aus einer ersten Sensorelektrode 1, einer Referenzelektrode 2, einer zweiten Sensorelektrode 3 und einer Anregungselektrode 4. Dieser in Fig. 1 dargestellten Elektrodenanordnung ist gegenüberliegend auf einem Drehelement eine in Fig. 2 dargestellte Koppelfläche 5 aus elektrisch leitendem Material angeordnet, die bei einer Drehbewegung des Drehelementes über die Elektrodenanordnung gemäß Fig. 1 bewegt wird.

In einer besonders bevorzugten Anordnung, auf welche die vorliegende Erfindung jedoch nicht beschränkt ist, ist die Anregungselektrode 4 kreisförmig aufgebaut, um welche herum die übrigen Elektroden, d.h. die erste und zweite Sensorelektrode 1, 3 sowie die Referenzelektrode 2 angeordnet sind. Die erste und zweite Sensorelektrode 1, 3 sind gleich ausgebildet und weisen die Form eines Kreissegmentes auf, wobei das Zentrum des Kreises im Mittelpunkt der Anregungselektrode 4 liegt. Die Sensorelektroden 1 und 3 decken dabei ein Winkelsegment von etwa 60° bezogen auf einen vollständigen Kreis ab. Auch die Referenzelektrode 2 ist als Kreissegment ausgebildet, wobei der Mittelpunkt auch dieses Kreises im Mittelpunkt der Anregungselektrode 4 liegt. Der durch die Referenzelektrode 2 abgedeckte Winkelbereich liegt, bezogen auf den vollständigen Kreis, bei etwa 145°.

Dabei ist die Tiefe der Referenzelektrode in radialer Richtung kleiner als die Tiefe der Sensorelektroden 1, 3 in radialer Richtung, wobei die Größen der Elektroden 1, 2, 3 vorzugsweise derart angepasst sind, dass die Spannungssignale von der ersten Sensorelektrode 1, der zweiten Sensorelektrode 3 und der Referenzelektrode 2 im Betrieb in der gleichen Größenordnung liegen.

Zwischen der ersten Sensorelektrode 1 und der zweiten Sensorelektrode 3 ist ein Zwischenraum 6 ausgebildet, in dem sich keine Elektrodenfläche befindet. Der Zwischenraum 6 umfasst etwa einen Winkelbereich von 50°. Der verbleibende, nicht durch Elektroden 1, 2, 3 abgedeckte Winkelbereich um die Anregungselektrode 4 ist gleichmäßig auf zwei weitere Zwischenräume 7, 8 zwischen der ersten Sensorelektrode 1 und der Referenzelektrode 2 bzw. der zweiten Sensorelektrode 3 und der Referenzelektrode 2 aufgeteilt, die gleich groß sind. Die erste Sensorelektrode 1, die zweite Sensorelektrode 3 und die Referenzelektrode 2 umgeben die Anregungselektrode 4 im Wesentlichen kreisförmig, wobei auch in radialer Richtung ein der Isolierung dienender Abstand zwischen der Anregungselektrode 4 und den übrigen Elektroden 1, 2, 3 besteht.

Insgesamt ist die Anordnung der Elektroden 1, 2, 3, 4 symmetrisch zu einer Symmetrieachse A ausgebildet, welche durch den Mittelpunkt der runden Anregungselektrode 4 verläuft und den Zwischenraum 6 zwischen der ersten Sensorelektrode 1 und der zweiten Sensorelektrode 3 symmetrisch teilt. Auf der bezogen auf die Anregungselektrode 4 dem Zwischenraum 6 gegenüberliegenden Seite teilt die Symmetrieachse A die Referenzelektrode 2 symmetrisch. Die gesamte Anordnung ist bezogen auf die Symmetrieachse A also spiegelsymmetrisch ausgebildet.

Die in Fig. 2 dargestellte Koppelfläche 5, die auf einem nicht dargestellten Drehelement auf- oder angebracht und gegenüber den Elektroden 1, 2, 3, 4 angeordnet ist, weist einen inneren kreisförmigen Abschnitt 9 und einen äußeren, den inneren Abschnitt 9 teilweise umgebenden halbkreisförmigen Abschnitt 10 auf. Der kreisförmige innere Abschnitt 9 geht dabei in den äußeren Abschnitt 10 über, so dass von dem kreisförmigen inneren Abschnitt 9 in der Kontur nur ein Halbkreis zu erkennen ist. Die Koppelfläche 5 ist aus einem leitfähigen Material, insbesondere einem metallischen Material, gebildet.

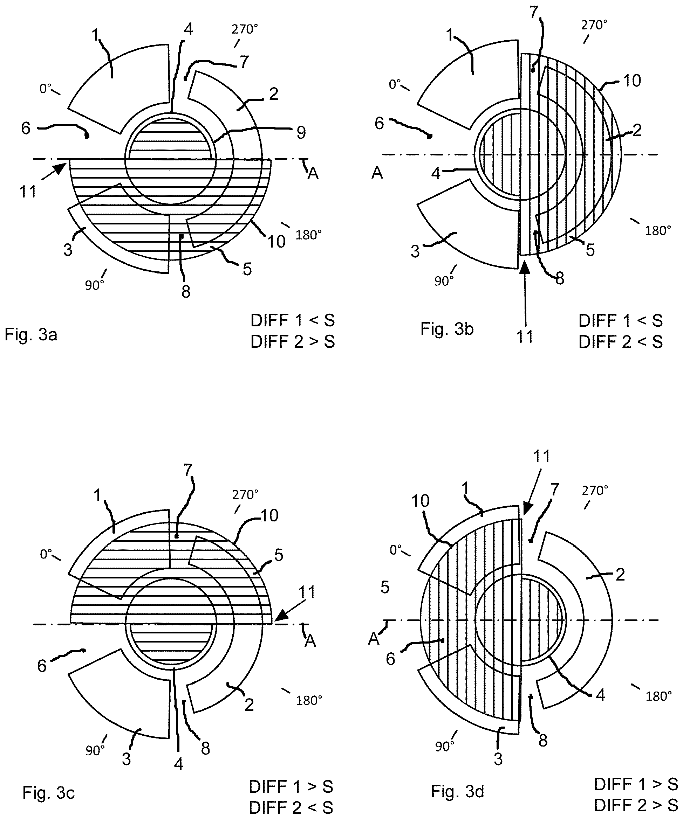

In den Fig. 3a bis 3d ist ein Montagezustand der erfindungsgemäßen Anordnung mit den Elektroden 1, 2, 3, 4 und der Koppelfläche 5 dargestellt, wobei die Koppelfläche 5 der Deutlichkeit halber durchsichtig dargestellt ist. In der Darstellung gemäß Fig. 3a überdeckt der innere Abschnitt 9 der Koppelfläche 5 im Wesentlichen die Anregungselektrode 4, wobei der Radius des inneren Abschnitts 9 der Koppelfläche 5 geringfügig kleiner ausgebildet ist als der Radius der Anregungselektrode 4. Diese Überdeckung gilt, wie die Fig. 3b bis 3d zeigen, in jeder Drehstellung der Koppelfläche 5 relativ zu den Elektroden 1, 2, 3, 4. Hierzu liegt die Drehachse der Koppelfläche 5 im Mittelpunkt des Kreises des inneren Abschnitts der Koppelfläche 5 und im Mittelpunkt der kreisförmigen Anregungselektrode 4.

Der äußere Abschnitt 10 der Koppelfläche 5 überdeckt in der Drehstellung gemäß Fig. 3a die zweite Sensorelektrode 3, die an die Sensorelektrode 2 anschließende eine Hälfte der Referenzelektrode 2 sowie den zwischen der zweiten Sensorelektrode 3 und der Referenzelektrode 2 ausgebildeten Zwischenraum 8 sowie die an die erste Sensorelektrode 3 anschließende eine Hälfte des Zwischenraums 6 zwischen der ersten Sensorelektrode 1 und der zweiten Sensorelektrode 3. In dieser Drehstellung findet eine kapazitive Kopplung der Anregungselektrode 4 mit der zweiten Sensorelektrode 3 und der Referenzelektrode 2 durch die Koppelfläche 5 statt.

In Fig. 3b wurde die Koppelfläche 5 im Vergleich zu der Drehstellung gemäß Fig. 3a um 90° nach links, d.h. entgegen dem Urzeigersinn, verdreht, so dass die Koppelfläche 5 mit dem äußeren Abschnitt 10 die Referenzelektrode 2 und die angrenzenden Zwischenräume 7, 8 überdeckt.

In der Darstellung gemäß Fig. 3c überdeckt der äußere Abschnitt 10 der Koppelfläche 5 die erste Sensorelektrode 1, die an die erste Sensorelektrode 1 anschließende eine Hälfte der Referenzelektrode 2, den zwischen der ersten Sensorelektrode 1 und der Referenzelektrode 2 ausgebildeten Zwischenraum 7 sowie die an die erste Sensorelektrode 1 anschließende eine Hälfte des Zwischenraums 6 zwischen der ersten Sensorelektrode 1 und der zweiten Sensorelektrode 2. In dieser Stellung wird durch die Koppelfläche 5 die Anregungselektrode 4 mit der ersten Sensorelektrode 1 und der Referenzelektrode 2 kapazitiv gekoppelt.

Fig. 3d zeigt schließlich eine weitere Drehung der Koppelfläche 5 um 90°, so dass die Koppelfläche 5 mit ihrem äußeren Abschnitt 10 nun die erste Sensorelektrode 1 und die zweite Sensorelektrode 3 sowie den zwischen der ersten Sensorelektrode 1 und der zweiten Sensorelektrode 3 ausgebildeten Zwischenraum 6 überdeckt. Es werden also die erste Sensorelektrode 1 und die zweite Sensorelektrode 3 kapazitiv gekoppelt.

Diese durch die Fig. 3a bis 3d quadrantenweise dargestellte Bewegung wird bei einer vollständigen Drehung der Koppelfläche 5 mit dem Drehelement über der Anordnung aus den Elektroden 1, 2, 3, 4 durchlaufen, wobei als Momentaufnahmen die Drehstellungen nach jeweils 90° dargestellt sind.

Unter dem Begriff "überdecken" wird verstanden, dass die Koppelfläche 5 mit ihrem äußeren Abschnitt 10 zumindest einen Teil der Flächen der ersten Sensorelektrode 1, der zweiten Sensorelektrode 3 bzw. der Referenzelektrode 2 überdeckt, so dass eine starke kapazitive Kopplung zwischen den überdeckten Elektroden 1, 2, 3 sowie der Anregungselektrode 4 stattfindet, wobei letztere Anregungselektrode 4 immer überdeckt ist. Eine vollständige Überdeckung des Bereichs der Elektroden 1, 2, 3, 4 durch die Koppelfläche 5 ist für eine Abdeckung in der Terminologie dieser Anmeldung nicht unbedingt notwendig.

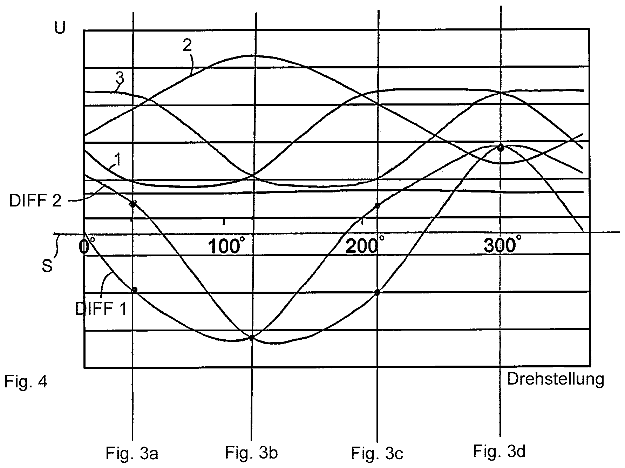

Wenn an der Anregungselektrode 4 eine Spannung anliegt, wird über die kapazitive Kopplung auf der Koppelfläche 5 eine Ladung induziert, welche dazu führt, dass die jeweils von der Koppelfläche 5 überdeckten Elektroden 1, 2, 3 je nach Drehstellung der Koppelfläche 5 miteinander kapazitiv gekoppelt werden und an den verschiedenen Elektroden 1, 2, 3 ein Spannungssignal nachweisbar ist, dessen Höhe je nach der Drehstellung der Koppelfläche 5 variiert. Fig. 4 zeigt den Verlauf der Spannung U in Abhängigkeit von der Drehstellung der Koppelfläche 5, wobei die Drehstellung in Grad und die Spannung in beliebigen Einheiten aufgetragen ist. Der angezeigte Winkel wird durch die Spitze 11 zur Winkelmessung der Koppelfläche 5 entsprechend den in den Fig. 1 und Fig. 3a bis 3d eingezeichneten Winkelstellungen definiert.

Die Spannungsverläufe sind der Einfachheit halber mit den jeweiligen Nummern der Elektroden 1, 2 ,3 bezeichnet, an denen die Spannung abgegriffen wird. In das Diagramm sind die Stellungen gemäß Fig. 3a bis Fig. 3d durch senkrechte, über das Diagramm herausragende und mit entsprechenden als Fig. 3a bis Fig. 3d bezeichnete Striche markiert. Bei der Stellung gemäß Fig. 3a ist die zweite Sensorelektrode 3 mit der Hälfte der Referenzelektrode 2 gekoppelt. Die an der zweiten Sensorelektrode 3 anliegende Spannung bewegt sich daher nahe dem Maximalwert. Entsprechend ist die nicht abgedeckte erste Sensorelektrode 1 in der Nähe ihres Minimalwertes. Die zur Hälfte abgedeckte Referenzelektrode 2 befindet sich etwa in der Mitte zwischen dem maximalen und dem minimalen Spannungswert.

In der Stellung gemäß Fig. 3b sind die erste Sensorelektrode 1 und die zweite Sensorelektrode 3 in symmetrischer Weise nicht abgedeckt, so dass ihre Spannungswerte gleich und vergleichsweise niedrig sind. Die vollständig abgedeckte Referenzelektrode 2 hat in dieser Stellung ihren Maximalwert.

Fig. 3c entspricht der Stellung gemäß Fig. 3a, wobei die Werte zwischen der ersten Sensorelektrode 1 und der zweiten Sensorelektrode 3 gerade getauscht sind, da in dieser Drehstellung die erste Sensorelektrode 1 durch die Koppelfläche 5 abgedeckt ist.

In der Drehstellung gemäß Fig. 3d sind die erste Sensorelektrode 1 und die zweite Sensorelektrode 3 durch die Koppelfläche 5 kapazitiv gekoppelt. Ihre Werte bewegen sich nahe den Maximalwerten und sind gleich. Die überhaupt nicht abgedeckte Referenzelektrode 2 hat in dieser Drehstellung ihren Minimalwert.

Als zusätzliche Kurven sind die erfindungsgemäß gebildeten Differenzwerte zwischen der ersten Sensorelektrode 1 und der Referenzelektrode (bezeichnet als DIFF 1) und die zweite Differenz zwischen der zweiten Sensorelektrode 3 und der Referenzelektrode (bezeichnet als DIFF 2) eingezeichnet.

Gut zu erkennen ist, dass der Phasenversatz zwischen dem Spannungsverlauf der ersten Sensorelektrode 1 und dem Spannungsverlauf der zweiten Sensorelektrode 3 gerade 90° (bezogen auf die Drehstellung des Koppelelementes) beträgt. Das Spannungssignal der Referenzelektrode 2 ist maximal, wenn die Spannungssignale der ersten Sensorelektrode 1 und der zweiten Sensorelektrode 3 in der Nähe ihres minimalen Spannungswertes gleich sind. Entsprechend ist das Spannungssignal der Referenzelektrode 2 minimal, wenn die Spannungswerte der ersten Sensorelektrode 1 und der zweiten Sensorelektrode 3 in der Nähe ihres Maximums gleich sind.

Durch die erfindungsgemäße Differenzbildung des Spannungsverlaufs der ersten Sensorelektrode 1 bzw. der zweiten Sensorelektrode 3 jeweils mit der Referenzelektrode 2 erhält man durch einen Vergleich der gebildeten Differenzen DIFF 1 und DIFF 2 mit einem Schwellenwert jeweils eine Aussage über die Drehstellung des Koppelelementes 5. Eine geeignete Schwelle ist in Fig. 4 als horizontale Linie S eingezeichnet. Diese Linie befindet sich etwa in der Mitte zwischen dem Maximalwert und dem Minimalwert der beiden Differenzkurven DIFF 1 und DIFF 2. In der Drehstellung gemäß Fig. 3a ist der Wert DIFF 1 < S und der Wert DIFF 2 > S. In der Stellung gemäß Fig. 3b sind beide Differenzwerte DIFF1, DIFF 2 < S. In der Drehstellung gemäß Fig. 3c ist der Differenzwert DIFF 1 > S und der Differenzwert DIFF 2 < S. In der Drehstellung gemäß Fig. 3d sind dagegen beide Differenzwerte DIFF 1 und DIFF 2 > S. In Fig. 4 sind die jeweiligen Funktionswerte an den Schnittlinien zu den die Drehstellung anzeigenden vertikalen Linien durch Punkte dargestellt. Der Vergleich mit den Schwellenwerten S ist unter den Darstellungen der Fig. 3a bis Fig. 3d aufgeführt.

Wie man dort übersichtlich erkennt, lassen sich die vier möglichen Konstellationen der Differenzwerte DIFF 1 und DIFF 2 im Vergleich zu dem Schwellenwert S jeweils einer um 90° gedrehten Drehstellung der Koppelfläche 5 zuweisen, so dass durch diese Auswertung der jeweilige Quadrant, in welcher sich die Koppelfläche 5 befindet, genau festgestellt werden kann.

Um die Position des Drehelements mit einer dem normalen Zählfortschritt des Zählers angepassten Frequenz überprüfen zu können, wird erfindungsgemäß vorgeschlagen, die Anregungselektrode 4 ausreichend hochfrequent mit Spannungspulsen zu beaufschlagen, so dass bei einer maximalen zu erwartenden Drehfrequenz des Zählers in jedem Quadrant mindestens eine Abtastung des Drehelementes stattfindet.

Da es sich bei den Zählern häufig um batteriebetriebene Geräte handelt und die von einer Batterie zur Verfügung gestellte nominale Versorgungsspannung zu niedrig ist, um mit einer einfachen elektronischen Auswertung eine ausreichend genaue Pulsantwort zu erreichen, wird erfindungsgemäß vorgeschlagen, Spannungspulse in einem durch die Batterie 21 betriebenen Stromkreis mittels einer Induktivität 22 zu erzeugen. Dazu wird der Batteriestromkreis durch einen Pulsgenerator bzw. Frequenzgeber 24 in der gewünschten Pulsfrequenz geschlossen, so dass an der Induktivität 22 die Batteriespannung anliegt. Dies führt zu einem Ladestrom an der Induktivität 22, wobei nach Öffnen des Stromkreises aufgrund des Verhaltens der Induktivität 22 zunächst weiter Strom fließt und dadurch kurzzeitig ein hoher Spannungspuls 13 erzeugt wird. Dies ist in Fig. 5 dargestellt, wobei die in dem Ladestromkreis bei geschlossenem Schalter 23 angelegte Batteriespannung 12 vorzugsweise so lange angelegt wird, bis ein bestimmter Ladestrom erreicht ist. Dann wird der Stromkreis geöffnet, was zu einem Abfall der Batteriespannung über der Induktivität 22 führt. Gleichzeitig entsteht durch die Induktivität 22 ein Spannungspuls 13 mit einer etwa um das 10- bis 15-fache höheren Spannung als der Batteriespannung 12. Dies ist in Fig. 5 durch die beiden verschiedenen Spannungsskalen dargestellt.

Der so erzeugte Spannungspuls 13 wird auf die Anregungselektrode 4 gegeben und über das Koppelelement 5 auf diejenigen Elektroden 1, 2, 3 übertragen, die gerade durch das Koppelelement 5 übergedeckt sind.

Fig. 6 zeigt ein an diesen Elektroden 1, 2, 3 abgreifbares Spannungssignal in Abhängigkeit davon, ob durch die Koppelfläche 5 eine starke, eine mittlere oder eine schwache kapazitive Kopplung erreicht wird. Der größte Sensorspannungspuls 14 wird an einer Sensor- oder Referenzelektrode 1, 2, 3 abgegriffen, wenn eine maximale kapazitive Kopplung besteht. Bei einer mittleren kapazitiven Kopplung wird der mittlere Sensorspannungspuls 15 und bei einer nur geringen kapazitiven Kopplung der niedrige Sensorspannungspuls 16 an der Elektrode 1, 2, 3 detektiert.

In den Fig. 7 und 8 sind nun die Sensorsignale der ersten Sensorelektrode 1 (Fig. 7) bzw. der zweiten Sensorelektrode 3 (Fig. 8) sowie jeweils der Referenzelektrode 2 dargestellt, wobei diese der Einfachheit halber mit den den Elektroden 1, 2, 3 zugeordneten Bezugszeichen gekennzeichnet sind. Mit einer anderen Skala ist ferner das Differenzsignal der beiden Spannungssignale der Sensorelektrode 1, 3 und der Referenzelektrode 2 dargestellt, welches als DIFF 1 bzw. DIFF 2 bezeichnet ist.

In Fig. 7 ist dieses Signal in dem Spannungspuls negativ, weil der Spannungswert der Referenzelektrode 2 größer ist als der Spannungswert der ersten Sensorelektrode 1. Ein Komparator 26, welcher die Differenz der beiden Signale bildet, liefert daher nur das Ausgangssignal 17 mit dem Wert 0. In Fig. 7 verwenden das Differenzsignal DIFF 1 sowie die Spannungssignale der ersten Sensorelektrode 1, der Referenzelektrode 2 und das Ausgangssignal 17 jeweils eine unterschiedliche Skalierung.

Entsprechendes gilt für die Darstellung in Fig. 8, welche das Spannungssignal der zweiten Sensorelektrode 3 und das Spannungssignal der Referenzelektrode 2 zeigt. Die Differenz DIFF 2 dieser beiden Signale ist im Spannungspuls größer als 0, weil der Spannungswert der Sensorelektrode 3 größer ist als der Spannungswert der Referenzelektrode 2. Dieses positive Differenzsignal DIFF 2 veranlasst einen Komparator 27, welcher die Differenz DIFF 2 der beiden Spannungssignale bildet, ein Ausgangssignal 18 ungleich 0 auszugeben.

Im Fall der Fig. 7 und 8 ist also der Wert DIFF 1 < S und der Wert DIFF 2 > S. Entsprechend befindet sich die Koppelfläche 5 in einer Drehstellung gemäß Fig. 3a.

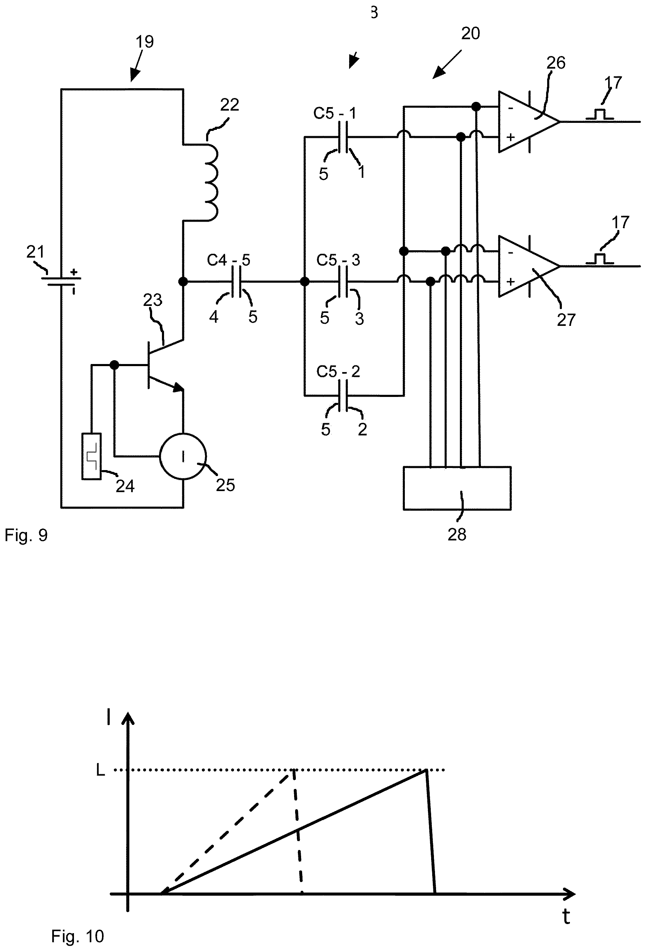

Fig. 9 zeigt schematisch ein logisches Schaltbild der Auswerteeinrichtung 18 der erfindungsgemäßen Anordnung. Die Auswerteeinrichtung 18 weist eine Anregungsschaltung 19 zur Erzeugung von Anregungspulsen in Form von Spannungspulsen 13 und eine Auswertungsschaltung 20 zum Erfassen der an den Elektroden 1, 2, 3, anliegenden Spannungssignale zum Vergleich dieser Spannungssignale auf. In der Anregungsschaltung 19 stellt eine Batterie 21 die Versorgungsspannung zur Verfügung, um mittels eines Ladestroms eine Induktivität 22 zu laden, wenn ein Schalter 23 durch einen Frequenzgeber 24 geschlossen wird, welcher die Frequenz der Spannungspulse 13 vorgibt. Bei geschlossenem Schalter 23 misst ein Strommesser 25 den Ladestrom der Induktivität 22, bis dieser einen Ladestromschwellenwert L erreicht. Hierdurch wird der Schalter 23 veranlasst, den Stromkreis zu unterbrechen. Im Anschluss daran fließt aufgrund der Induktivität 22 noch weiter Strom, wodurch ein Spannungspuls 13 erzeugt wird, der auf die Anregungselektrode 4 ausgegeben wird.

Die Anregungselektrode 4 ist über den inneren Abschnitt 9 der Koppelfläche 5 kapazitiv mit der Koppelfläche 5 gekoppelt, die ihrerseits je nach Drehstellung mit der ersten Sensorelektrode 1, der zweiten Sensorelektrode 3 oder der Referenzelektrode 2 kapazitiv koppelt. Hierdurch kann an der ersten Sensorelektrode 1, an der zweiten Sensorelektrode 3 und an der Referenzelektrode 2 jeweils ein Spannungswert abgegriffen werden, die einem ersten Komparator 26, welcher das Differenzsignal DIFF 1 bildet, und einem zweiten Komparator 27, welcher das Differenzsignal DIFF 2 bildet, zugeleitet werden. Der Schwellenwert S wird in den Zuleitungen zu dem ersten bzw. zweiten Komparator 26, 27 durch eine Arbeitspunkteinstellung 28 eingestellt, die bspw. geeignete Spannungsteiler aufweist, um die den Komparatoren 26, 27 zugeleiteten Spannungsniveaus entsprechend zu verschieben.

Der erste Komparator 26 und der zweite Komparator 27 geben je nach dem Ergebnis der Differenzbildung in der beschriebenen Weise das Ausgangssignal 17 aus, welches entweder 0 ist oder von 0 verschieden ist. Dieses Ausgangssignal 17 wird dann zur Dreherkennung, Positionserkennung und Drehrichtungserkennung des Drehelementes herangezogen.

Fig. 10 zeigt das Verhalten des Ladestroms in dem Anregungsstromkreis 19 bei geschlossenem Schalter 23. Wie Fig. 10 an der Stromkurve zu entnehmen, steigt der Ladestrom während des Ladevorgangs an, bis in dem Strommesser 25 der Ladestromschwellwert L gemessen wird und der Schalter 23 daraufhin geöffnet wird. Die Höhe des Anregungspulses 13 hängt dann insbesondere auch von der unter der Kurve gesammelten Ladungsmenge ab.

Das Festlegen eines Ladestromschwellwertes L als Grenzwert für das Öffnen des Schalters 23 hat den Vorteil, dass eine Überladung der Induktivität 22 nicht vorkommen kann.

Dieser Lademechanismus kann gemäß einer erfindungsgemäßen Ausgestaltung auch als Manipulationserkennung für die Manipulation des Zählers mit einem externen Magnetfeld verwendet werden. Dieses könnte bspw. dazu führen, dass bei einer Magnetankopplung des Drehelementes der erfindungsgemäßen Anordnung an ein den Verbrauch feststellendes Zählerelement ein Durchrutschen der Magnetkupplung bewirkt werden kann und so der Zählerfortschritt beeinflusst wird. Daher handelt es sich hierbei um eine in der Praxis häufig angewendete Manipulation.

Diese Manipulation kann erfindungsgemäß nun dadurch erkannt werden, dass durch das externe Magnetfeld die Induktivität 22 verändert wird. Dies führt zu einem schnelleren Ansteigen des Ladestroms, wie in Fig. 10 durch die gestrichelte Linie dargestellt. In diesem Fall wird der Ladestromschwellenwert L innerhalb einer kürzeren Zeit erreicht als bei einer Normladung, wie sie entsprechend der durchgezogenen Linie stattfindet. Durch Messung der Ladezeit bis zum Erreichen des Ladestromschwellenwertes L kann daher entschieden werden, ob die gesamte Sensoranordnung mit einem externen Magnetfeld beeinflusst wird.

Diese Manipulationserkennung ist besonders einfach durchzuführen, weil keine gesonderten elektronischen Bauteile vorgesehen werden müssen. Die Zeit vom Schließen des Schalters bis zum Erreichen des Ladestromschwellwertes kann bspw. mit einem in der Anordnung ohnehin vorgesehenen Mikroprozessor erfasst werden.

### Bezugszeichenliste:

- 1: erste Sensorelektrode
- 2: Referenzelektrode
- 3: zweite Sensorelektrode
- 4: Anregungselektrode
- 5: Koppelfläche
- 6: Zwischenraum
- 7: Zwischenraum
- 8: Zwischenraum
- 9: innerer Abschnitt
- 10: äußerer Abschnitt
- 11: Spitze zur Winkelmessung
- 12: Batteriespannung
- 13: Spannungspuls, Anregungspuls
- 14: großer Sensorspannungspuls
- 15: mittlerer Sensorspannungspuls
- 16: niedriger Sensorspannungsplus
- 17: Ausgangssignal
- 18: Auswerteeinrichtung
- 19: Anregungsschaltung
- 20: Auswertungsschaltung
- 21: Batterie
- 22: Induktivität
- 23: Schalter
- 24: Frequenzgeber
- 25: Einrichtung zur Strommessung, Strommesser
- 26: erster Komparator
- 27: zweiter Komparator
- 28: Arbeitspunkteinstellung

- A: Symmetrieachse
- S: Schwellenwert
- L: Ladestromschwellenwert
- DIFF1: Differenz des Spannungssignals der ersten Sensorelektrode und der Referenzelektrode
- DIFF2: Differenz des Spannungssignals der zweiten Sensorelektrode und der Referenzelektrode

## Patentansprüche

1. Anordnung zur kapazitiven Abtastung der Drehbewegung eines Drehelements, wobei die Anordnung vier in einer Ebene angeordnete Elektroden (1, 2, 3, 4), eine an die Elektroden (1, 2, 3, 4) angeschlossene Auswerteeinrichtung (18) und eine elektrisch leitende Koppelfläche (5) aufweist, welche an dem Drehelement den Elektroden (1, 2, 3, 4) gegenüberliegend angeordnet ist, wobei die Elektroden (1, 2, 3, 4) eine zentrale Anregungselektrode (4) umfassen, um die herum die übrigen Elektroden (1, 2, 3) angeordnet sind,
wobei die Koppelfläche (5) in jeder Drehstellung der Fläche der Anregungselektrode (4) gegenüberliegt und einen Teil der durch die übrigen Elektroden (1, 2, 3) gebildeten Fläche abdeckt sowie bei einer Drehung des Drehelements verschiedene Bereiche der durch die übrigen Elektroden (1, 2, 3) gebildeten Fläche überstreicht, und
wobei die Auswerteeinrichtung (18) zum zeitaufgelösten Nachweis der Drehstellung des Drehelementes eine an die Anregungselektrode (4) angeschlossene Anregungsschaltung (19) zur Erzeugung von Anregungspulsen (13) mit einer vorgegebenen Frequenz und eine an die übrigen Elektroden (1, 2, 3) angeschlossene Auswertungsschaltung (20) zum Erfassen der an den übrigen Elektroden (1, 2, 3) anliegenden Spannungssignale und zum Vergleichen dieser Spannungssignale aufweist,
**dadurch gekennzeichnet, dass** die übrigen Elektroden (1, 2, 3) durch zwei Sensorelektroden (1, 3) und eine gemeinsame Referenzelektrode (2) gebildet sind, wobei zumindest die gemeinsame Referenzelektrode (2) von den Sensorelektroden (1, 3) verschieden ausgebildet ist, und dass die Auswertungsschaltung (20) derart ausgebildet ist, dass zur Bestimmung der Bewegung und der Drehstellung des Drehelements jeweils eine Differenz (DIFF1, DIFF2) des Spannungssignals zwischen einer der beiden Sensorelektroden (1, 3) und der gemeinsamen Referenzelektrode (2) gebildet wird.

2. Anordnung nach Anspruch 1, **dadurch gekennzeichnet, dass** bezogen auf die Anregungselektrode (4), die Sensorelektroden (1, 3) und die Referenzelektrode (2) eine Symmetrieachse (A) existiert, bezüglich derer die Form und Position der Elektroden (1, 2, 3, 4) in der Anordnung spiegelsymmetrisch ist.

3. Anordnung nach Anspruch 1 oder 2, **dadurch gekennzeichnet, dass** die übrigen Elektroden (1, 2, 3) die Anregungselektrode (4) im Wesentlichen kreisförmig umgeben, wobei zwischen den beiden Sensorelektroden (1, 3) und zwischen jeder Sensorelektrode (1, 3) und der Referenzelektrode (2) jeweils ein Zwischenraum (6, 7, 8) besteht.

4. Anordnung nach einem der vorhergehenden Ansprüche, **dadurch gekennzeichnet, dass** die Referenzelektrode (2) derart dimensioniert ist, dass die Koppelfläche (5) in einer Drehstellung des Drehelements genau die Fläche der Referenzelektrode (2), ggf. mit den angrenzenden Zwischenräumen (7, 8), abdeckt.

5. Anordnung nach einem der vorhergehenden Ansprüche, **dadurch gekennzeichnet, dass** die Anregungselektrode (4) kreisförmig und die Koppelfläche (5) in einem inneren Abschnitt (9) kreisförmig und in einem den inneren Abschnitt (9) teilweise umgebenden äußeren Abschnitt (10) halbkreisförmig ausgebildet sind und dass die gemeinsame Referenzelektrode (2) einen Winkelbereich von etwa 140° bis 150° und jede Sensorelektrode (1, 3) einen Winkelbereich von etwa 50° bis 70° abdecken.

6. Anordnung nach einem der vorhergehenden Ansprüche, **dadurch gekennzeichnet, dass** die Auswertungsschaltung (20) zwei Komparatoren (26, 27) aufweist, die jeweils die Differenz (DIFF1, DIFF2) zwischen dem Spannungssignal der einen bzw. der anderen Sensorelektrode (1, 3) und dem Spannungssignal der Referenzelektrode (2) bilden, wobei ein Komparator (26, 27) nur bei einem oberhalb eines einstellbaren Schwellwertes liegenden Differenzwert ein Ausgangssignal (17) gibt.

7. Anordnung nach einem der vorhergehenden Ansprüche, **dadurch gekennzeichnet, dass** die Anregungsschaltung (19) einen an die Versorgungsspannung einer Batterie (21) angeschlossenen Stromkreis mit einer Induktivität (22), einem Schalter (23) und einer Einrichtung zur Strommessung (25) aufweist, wobei die Anregungsschaltung (19) dazu eingerichtet ist, den Schalter (23) des Stromkreises zum Laden der Induktivität (22) mit einem Ladestrom zu schließen und den Schalter (23) bei Erreichen eines Ladestromschwellenwertes (L) zur Erzeugung des Anregungspulses (13) wieder zu öffnen, wobei die Anregungsschaltung (19) weiter dazu eingerichtet ist, zur Manipulationsüberwachung die Ladezeit zwischen dem Schließen des Schalters (23) und dem Erreichen des Ladestromwellenwertes (L) zu messen.

8. Verfahren zur kapazitiven Abtastung der Drehbewegung eines Drehelements mit einer Anordnung aus einer zentralen Anregungselektrode (4) sowie einer Referenzelektrode (2) und zwei Sensorelektroden (1, 3), welche die zentrale Anregungselektrode (4) umgeben, wobei zumindest die Referenzelektrode (2) von den Sensorelektroden (1, 3) verschieden ausgebildet ist und die Anregungselektrode (4), die Referenzelektrode (2) und die Sensorelektroden (1, 3) in einer Ebene angeordnet sind und gegenüber einer an dem Drehelement vorgesehenen Koppelfläche (5) angeordnet sind, welche Koppelfläche die Anregungselektrode (4) sowie je nach Drehstellung Teile der übrigen Elektroden (1, 2, 3) zur drehstellungsabhängigen kapazitiven Kopplung der Anregungselektrode (4) mit der Referenzelektrode (2) und den zwei Sensorelektroden (1, 3) überdeckt, bei welchem Verfahren die Anregungselektrode (4) in einer vorgegebenen Frequenz mit Anregungspulsen (13) beaufschlagt wird, wobei die Spannungen der Referenzelektrode (2), der ersten Sensorelektrode (1) und der zweiten Sensorelektrode (3) gemessen werden, **dadurch gekennzeichnet, dass** die Differenzen (DIFF1, DIFF2) der Spannung der einen und der anderen Sensorelektrode (1, 3) jeweils mit der Spannung der Referenzelektrode (2) gebildet und ausgewertet werden, um die Bewegung und die Drehstellung des Drehelements zu bestimmen.

9. Verfahren nach Anspruch 8, **dadurch gekennzeichnet, dass** jeweils in einem Komparator (26, 27) einer Auswertungsschaltung (20) bei einer oberhalb eines Schwellenwertes (S) liegenden Differenz (DIFF1) der Spannungen der einen Sensorelektrode (1) und der Referenzelektrode (2) und bei einer oberhalb eines, vorzugsweise desselben, Schwellenwertes (S) liegenden Differenz (DIFF2) der Spannungen der anderen Sensorelektrode (3) und der Referenzelektrode (2) ein Ausgangssignal (17) erzeugt wird.

10. Verfahren nach Anspruch 8 oder 9, **dadurch gekennzeichnet, dass** ein an die Anregungselektrode (4) abgegebener Anregungspuls (13) erzeugt wird, indem ein Schalter (23) in einem an eine Batterie (21) angeschlossenen und eine Induktivität (22) enthaltenen Stromkreis geschlossen und der Ladestrom überwacht wird, wobei der Schalter (23) geöffnet wird, wenn der Ladestrom einen Ladestromschwellenwert (L) erreicht.

11. Verfahren nach Anspruch 10, **dadurch gekennzeichnet, dass** die Ladezeit vom Schließen des Schalters (23) bis zum Erreichen des Ladestromschwellenwertes (L) überwacht wird.

12. Verfahren nach Anspruch 10, **dadurch gekennzeichnet, dass** bei Über- und/oder Unterschreiten einer als Grenzwert vorgebbaren Ladezeit bis zum Erreichen des Ladestromschwellenwertes (L) ein Fehlersignal erzeugt wird.

13. Verwendung einer Anordnung nach einem der Ansprüche 1 bis 7 in einem Verbrauchszähler, insbesondere einem Wasser-, Gas- oder Stromzähler, welcher einen drehbaren Verbrauchssensor mit einer Kupplung aufweist, an welchen das Drehelement der Anordnung gemäß einem der Ansprüche 1 bis 7 ankoppelbar ist, wobei der Verbrauchszähler eine Recheneinheit zur Auswertung der durch die Anordnung gelieferten Drehstellung des Drehelements und zur Umsetzung in Verbrauchswerte aufweist.

## Claims

1. Arrangement for capacitive sensing of the rotary movement of a rotating element, wherein the arrangement comprises four electrodes (1, 2, 3, 4) arranged in a plane, an evaluation unit (18) connected to the electrodes (1, 2, 3, 4) and an electrically conductive coupling surface (5), which is arranged on the rotary element of the electrode (1, 2, 3, 4) opposite the electrodes,
wherein the electrodes (1, 2, 3, 4) comprise a central excitation electrode (4) around which the remaining electrodes (1, 2, 3) are arranged,
wherein in each rotational position of the surface the coupling surface (5) lies opposite the excitationelectrode (4) and covers a part of the surface formed by the remaining electrodes (1, 2, 3), and sweeps over different areas of the surface formed by the remaining electrodes (1, 2, 3) during rotation of the rotary element, and
wherein to provide a time-resolved identification of the rotational position of the rotating element, the evaluation device (18) comprises an excitation circuit (19) connected to the excitation electrode (4) for generating excitation pulses (13) with a specified frequency and an evaluation circuit (20) connected to the remaining electrodes (1, 2, 3) for detecting the voltage signals applied to the remaining electrodes (1, 2, 3) and for comparing said voltage signals,
**characterized in that**
the remaining electrodes (1, 2, 3) are formed by means of two sensor electrodes (1, 3) and a common reference electrode (2), wherein at least the common reference electrode (2) is designed differently to the sensor electrodes (1, 3), and that the evaluation circuit (20) is designed in such a way that, to determine the movement and the rotational position of the rotary element, in each case a difference (DIFF1, DIFF2) of the voltage signal between one of the two sensor electrodes (1, 3) and the common reference electrode (2) is formed.

2. The arrangement according to Claim 1,
**characterized in that**
in relation to the excitation electrode (4), the sensor electrodes (1, 3) and the reference electrode (2) an axis of symmetry (A) exists, with respect to which the shape and position of the electrodes (1, 2, 3, 4) in the arrangement is mirror-symmetric.

3. Arrangement according to Claim 1 or 2,
**characterized in that**
the remaining electrodes (1, 2, 3) surround the excitation electrode (4) in a substantially circular fashion, wherein an intermediate space (6, 7, 8) exists between the two sensor electrodes (1, 3) and between each sensor electrode (1, 3) and the reference electrode (2).

4. Arrangement according to any one of the previous claims,
**characterized in that**
the reference electrode (2) is dimensioned such that in a rotational position of the rotary element the coupling surface (5) exactly covers the surface of the reference electrode (2), possibly including the adjacent intermediate spaces (7, 8).

5. Arrangement according to any one of the previous claims,
**characterized in that**
the excitation electrode (4) is designed circular and the coupling surface (5) is designed circular in an inner section (9) and semi-circular in an outer section (10) partially surrounding the inner section (9), and that the common reference electrode (2) covers an angular range of approximately 140° to 150° and each sensor electrode (1, 3) covers an angular range of approximately 50° to 70°.

6. Arrangement according to any one of the previous claims,
**characterized in that**
the evaluation circuit (20) comprises two comparators (26, 27), which respectively form the difference values (DIFF1, DIFF2) between the voltage signal of one or the other sensor electrode (1, 3) and the voltage signal of the reference electrode (2), wherein a comparator (26, 27) gives an output signal (17) only if the difference value is is above an adjustable threshold value.

7. Arrangement according to any one of the previous claims,
**characterized in that**
the excitation circuit (19) comprises an electrical circuit connected to the supply voltage of a battery (21), having an inductance (22), a switch (23) and a device for measuring current (25), wherein the excitation circuit (19) is configured for closing the switch (23) of the electrical circuit to charge the inductance (22) with a charging current, and for opening the switch (23) again on reaching a charging current threshold value (L) for generating the excitation pulse (13), wherein the excitation circuit (19) is further configured for measuring the charging time between the closure of the switch (23) and the reaching of the charging current threshold value (L) for the purpose of manipulation monitoring.

8. Method for capacitive sensing of the rotary movement of a rotating element, having an arrangement of a central excitation electrode (4) and a reference electrode (2) and two sensor electrodes (1, 3) which surround the central excitation electrode (4), wherein at least the reference electrode (2) is designed differently from the sensor electrodes (1, 3) and the excitation electrode (4), the reference electrode (2) and the sensor electrodes (1, 3) are arranged in a plane and opposite a coupling surface (5) which is arranged on the rotating element, which coupling surface overlaps the excitation electrode (4) and depending on the rotational position, parts of the remaining electrodes (1, 2, 3), for the purpose of rotary position-dependent capacitive coupling of the excitation electrode (4) to the reference electrode (2) and to the two sensor electrodes (1, 3), in which method the excitation electrode (4) is supplied with excitation pulses (13) at a predefined frequency, wherein the voltages of the reference electrode (2), the first sensor electrode (1) and the second sensor electrode (3) are measured,
**characterized in that**
the differences (DlFF1, DlFF2) of the voltage of the one and the other sensor electrode (1, 3) from the voltage of the reference electrode (2) are formed and evaluated in each case, in order to determine the movement and the rotary position of the rotating element.

9. Method according to Claim 8,
**characterized in that**
in each case in a comparator (26, 27) of an evaluation circuit (20), if a difference (DIFF1) between the voltages of the one sensor electrode (1) and the reference electrode (2) is above a threshold value (S) and if a difference (DIFF2) between the voltages of the other sensor electrode (3) and the reference electrode (2) is above a threshold value (S), which is preferably the same, an output signal is generated (17).

10. Method according to Claim 8 or 9,
**characterized in that**
an excitation pulse (13) output to the excitation electrode (4) is generated, by a switch (23) in a circuit which is connected to a battery (21) and contains an inductance (22) being closed and the charging current being monitored, wherein the switch (23) is opened when the charging current reaches a charging current threshold value (L).

11. Method according to Claim 10,
**characterized in that**
the charging time from the closure of the switch (23) to reaching the charging current threshold value (L) is monitored.

12. Method according to Claim 10,
**characterized in that**
if a charging time taken to reach the charging current threshold value (L), which can be specified as a limit value, is exceeded or undershot, an error signal is generated.

13. Use of an arrangement according to any one of Claims 1 to 7 in a usage meter, in particular a water, gas or electricity meter, which comprises a rotary usage sensor with a coupling to which the rotary element of the arrangement in accordance with any of Claims 1 to 7 can be coupled, said usage meter comprising an arithmetic unit for evaluating the rotational position of the rotary element delivered by the arrangement and converting it into usage values.

## Revendications

1. Agencement pour la détection capacitive du mouvement de rotation d'un élément rotatif, dans lequel l'agencement présente quatre électrodes (1, 2, 3, 4) disposées dans un plan, un dispositif d'analyse (18) raccordé aux électrodes (1, 2, 3, 4) et une surface de couplage électroconductrice (5), laquelle est disposée sur l'élément rotatif de manière située en vis-à-vis des électrodes (1, 2, 3, 4),
dans lequel les électrodes (1, 2, 3, 4) comprennent une électrode d'excitation centrale (4) autour de laquelle les autres électrodes (1, 2, 3) sont disposées,
dans lequel, dans chaque position de rotation, la surface de couplage (5) est située en vis-à-vis de la surface de l'électrode d'excitation (4) et recouvre une partie de la surface formée par les électrodes (1, 2, 3) restantes, ainsi qu'en cas d'une rotation de l'élément rotatif, balaye différentes zones de la surface formée par les électrodes (1, 2, 3) restantes,
et
dans lequel le dispositif d'analyse (18) présente, pour la preuve résolue dans le temps de la position de rotation de l'élément rotatif, un circuit d'excitation (19) raccordé à l'électrode d'excitation (4) pour la génération d'impulsions d'excitation (13) avec une fréquence prescrite et un circuit d'analyse (20) raccordé aux électrodes (1, 2, 3) restantes pour détecter les signaux de tension appliqués aux électrodes (1, 2, 3) restantes et pour comparer ces signaux de tension,
**caractérisé en ce que** les électrodes (1, 2, 3) restantes sont formées par deux électrodes de détection (1, 3) et une électrode de référence commune (2), dans lequel au moins l'électrode de référence commune (2) est réalisée différemment des électrodes de détection (1, 3), et **en ce que** le circuit d'analyse (20) est réalisé d'une façon telle, que pour la détermination du mouvement et de la position de rotation de l'élément rotatif, on forme respectivement une différence (DIFF1, DIFF2) du signal de tension entre l'une des deux électrodes de détection (1, 3) et l'électrode de référence commune (2).

2. Agencement selon la revendication 1, **caractérisé en ce que**, compte tenu de l'électrode d'excitation (4), des électrodes de détection (1, 3) et de l'électrode de référence (2), il existe un axe de symétrie (A) compte tenu duquel la forme et la position des électrodes (1, 2, 3, 4) dans l'agencement est à symétrie spéculaire.

3. Agencement selon la revendication 1 ou 2, **caractérisé en ce que** les électrodes restantes (1, 2, 3) entourent l'électrode d'excitation (4) sensiblement en forme de cercle, dans lequel il y a, entre les deux électrodes de détection (1, 3) et entre chaque électrode de détection (1, 3) et l'électrode de référence (2), respectivement un espace intermédiaire (6, 7, 8).

4. Agencement selon l'une des revendications précédentes, **caractérisé en ce que** l'électrode de référence (2) est dimensionnée d'une façon telle, que dans une position de rotation de l'élément rotatif, la surface de couplage (5) recouvre exactement la surface de l'électrode de référence (2), le cas échéant avec les espaces intermédiaires adjacents (7, 8).

5. Agencement selon l'une des revendications précédentes, **caractérisé en ce que** l'électrode d'excitation (4) est réalisée avec une forme circulaire et la surface de couplage (5) est réalisée avec une forme circulaire dans une partie intérieure (9) et avec une forme semi-circulaire dans une partie extérieure (10) entourant partiellement la partie intérieure (9), et **en ce que** l'électrode de référence commune (2) recouvre une plage angulaire de près de 140° à 150° et **en ce que** chaque électrode de détection (1, 3) recouvre une plage angulaire de près de 50° à 70°.

6. Agencement selon l'une des revendications précédentes, **caractérisé en ce que** le circuit d'analyse (20) présente deux comparateurs (26, 27), lesquels forment respectivement la différence (DIFF1, DIFF2) entre le signal de tension de l'une ou l'autre des électrodes de détection (1, 3) et le signal de tension de l'électrode de référence (2), dans lequel un comparateur (26, 27) donne un signal de sortie (17) seulement en cas d'une valeur de différence située au-dessus d'une valeur de seuil réglable.

7. Agencement selon l'une des revendications précédentes, **caractérisé en ce que** le circuit d'excitation (19) présente un circuit électrique - raccordé à la tension d'alimentation d'une batterie (21) - avec une inductance (22), un interrupteur (23) et un dispositif pour la mesure du courant (25), dans lequel le circuit d'excitation (19) est étudié pour fermer l'interrupteur (23) du circuit électrique pour charger l'inductance (22) avec un courant de charge et pour de nouveau ouvrir l'interrupteur (23) à l'atteinte d'une valeur de seuil de courant de charge (L) pour la génération de l'impulsion d'excitation (13), dans lequel le circuit d'excitation (19) est en outre étudié, pour la surveillance de manipulation, pour mesurer le temps de charge entre la fermeture de l'interrupteur (23) et l'atteinte de la valeur de seuil de courant de charge (L).

8. Procédé pour la détection capacitive du mouvement de rotation d'un élément rotatif avec un agencement formé par une électrode d'excitation centrale (4) ainsi qu'une électrode de référence (2) et deux électrodes de détection (1, 3) qui entourent l'électrode d'excitation centrale (4), dans lequel au moins l'électrode de référence (2) est réalisée différemment des électrodes de détection (1, 3), et l'électrode d'excitation (4), l'électrode de référence (2) et les électrodes de détection (1, 3) étant disposées dans un plan et disposées en vis-à-vis d'une surface d'accouplement (5) prévue sur l'élément rotatif, laquelle surface d'accouplement recouvre l'électrode d'excitation (4) ainsi que, selon la position de rotation, des parties des électrodes restantes (1, 2, 3) pour le couplage capacitif en fonction de la position de rotation de l'électrode d'excitation (4) avec l'électrode de référence (2) et les deux électrodes de détection (1, 3), dans lequel procédé on applique à l'électrode d'excitation (4) des impulsions d'excitation (13) à une fréquence prescrite, dans lequel les tensions de l'électrode de référence (2), de la première électrode de détection (1) et de la deuxième électrode de détection (3) sont mesurées,
**caractérisé en ce que** les différences (DIFF1, DIFF2) de la tension de l'une et de l'autre des électrodes de détection (1, 3) sont respectivement formées avec la tension de l'électrode de référence (2) et analysées pour déterminer le mouvement et la position de rotation de l'élément rotatif.

9. Procédé selon la revendication 8, **caractérisé en ce que**, respectivement dans un comparateur (26, 27) d'un circuit d'analyse (20), en cas d'une différence (DIFF1) des tensions située au-dessus d'une valeur de seuil (S) de l'une des électrodes de détection (1) et de l'électrode de référence (2), et en cas d'une différence (DIFF2) des tensions située au-dessus d'une valeur de seuil (S), de préférence la même, de l'autre électrode de détection (3) et de l'électrode de référence (2), un signal de sortie (17) est généré.

10. Procédé selon la revendication 8 ou 9, **caractérisé en ce qu'**une impulsion d'excitation (13) appliquée à l'électrode d'excitation (4) est générée **en ce qu'**un interrupteur (23) dans un circuit électrique raccordé à une batterie (21) et contenant une inductance (22) est fermé et **en ce que** le courant de charge est surveillé, dans lequel l'interrupteur (23) est ouvert lorsque le courant de charge atteint une valeur de seuil de courant de charge (L).

11. Procédé selon la revendication 10, **caractérisé en ce que** le temps de charge depuis la fermeture de l'interrupteur (23) jusqu'à l'atteinte de la valeur de seuil de courant de charge (L) est surveillé.

12. Procédé selon la revendication 10, **caractérisé en ce que**, lors du dépassement par le haut ou le bas d'un temps de charge prescriptible en tant que valeur de seuil jusqu'à l'atteinte de la valeur de seuil de courant de charge (L), un signal d'erreur est généré.

13. Utilisation d'un agencement selon l'une des revendications 1 à 7 dans un compteur de consommation, en particulier un compteur d'eau, de gaz ou de courant, lequel présente un détecteur de consommation rotatif avec un couplage auquel l'élément rotatif de l'agencement selon l'une des revendications 1 à 7 peut être accouplé, dans laquelle le compteur de consommation présente une unité de calcul pour l'analyse de la position de rotation de l'élément rotatif fournie par l'agencement et pour la conversion en valeurs de consommation.
